# EUROPÄISCHE PATENTSCHRIFT

(11) **EP 3 349 043 B1**
(45) Veröffentlichungstag und Bekanntmachung des Hinweises auf die Patenterteilung: **05.01.2022**
(21) Anmeldenummer: 17151300.5
(22) Anmeldetag: 13.01.2017
(51) Int. Cl.: G01S 17/89

(54) **VERFAHREN ZUM AUSLESEN EINES DEMODULATIONSPIXELS SOWIE ENTFERNUNGSSENSOR**
METHOD FOR READING A DEMODULATION PIXEL AND DISTANCE SENSOR
PROCÉDÉ DE LECTURE D'UN PIXEL DE DÉMODULATION ET CAPTEUR DE DISTANCE

(43) Veröffentlichungstag der Anmeldung: 18.07.2018
(73) Patentinhaber: Espros Photonics AG, 7320 Sargans (CH)
(72) Erfinder: DE COI, Beat, 7304 Maienfeld (CH); POPP, Martin, 7000 Chur (CH)
(74) Vertreter: Otten, Roth, Dobler & Partner mbB Patentanwälte

(56) Entgegenhaltungen:
- EP-A1- 2 187 237
- EP-A1- 2 743 724
- WO-A1-2010/144616
- US-A1- 2008 079 833

## Beschreibung

Die Erfindung betrifft ein Verfahren zum Auslesen eines Demodulationspixels nach dem Oberbegriff des Anspruchs 1 sowie einen Entfernungssensor nach dem Oberbegriff des Anspruchs Unter anderem ist aus der WO 2010/144616 A1 ein sogenanntes Minimum-Charge-Transfer-Verfahren (MCT) bekannt. Der die zu übermittelnde Information tragende Anteil eines optischen Signals ist regelmäßig von einem beliebigen Untergrund (Hintergrundlicht usw.) überlagert. Um diesen Hintergrund zu eliminieren, kann das optische Signal zunächst mit zwei Kanälen eines Photodetektors aufgenommen werden, wobei die einfallenden Photonen im Photodetektor bewegliche Ladungsträger induzieren. Anschließend wird ausgenutzt bzw. unterstellt, dass der Hintergrundanteil zu gleichen Anteilen in beiden Kanälen aufgeteilten Ladungsträgermengen vorkommt, sodass die Differenz aus entsprechenden Ladungsträgermengen bestimmt werden kann, um diesen Hintergrundanteil zu eliminieren. Die Ladungsträger können zunächst über eine gewisse Zeitspanne jeweils in einer Sammeleinheit (Storagegate) gesammelt werden. Zudem wird ein zweiter Bereich (zum Beispiel eine Floating-Diffusion) bereitgestellt, dessen Potential gemessen werden kann, wobei ein Übergang der Ladungsträger aus dem Storagegate in die Floating-Diffusion zunächst durch eine Barriere, die durch ein sog. Transfer-Gate gebildet wird, versperrt ist. Die jeweils aufgeteilten Ladungsträgermengen sind somit in den jeweiligen Storagegates, also gewissermaßen in einem Potentialtopf gefangen, während sie dort gesammelt werden. Durch Änderung des Potentials des jeweiligen Storagegates wird nach dem MCT-Verfahren die Topftiefe der Storagegates so lange verringert, bis aus einem der Storagegates Ladungen die Potentialbarriere des Transfergates überwinden und zur entsprechenden Floating-Diffusion fließen können. Bei unterschiedlichen Ladungsträgermengen in den Floating-Diffusions werden bei kontinuierlicher Veränderung der Topftiefe der Storagegates zunächst Ladungsträger nur aus einem Storagegate zur Floating-Diffusion abfließen können und dann, bei weiterer Verringerung der Topftiefe aus beiden. Aus den so bestimmbaren Potentialunterschieden ergibt sich die Differenz der beiden Ladungsmengen. Weitere Verfahren zum Auslesen eines Demodulationspixels sind auch aus EP 2 187 237 A1 und EP 2 743 724 A1 bekannt.

Aufgabe der Erfindung ist es, ein Verfahren zum Auslesen eines Demodulationspixels bzw. einen Entfernungssensor bereitstellen zu können, welches eine schnellere Verarbeitung ermöglicht. Die Aufgabe wird, ausgehend von einem Verfahren bzw. einem Entfernungssensor der eingangs genannten Art, durch die kennzeichnenden Merkmale der jeweiligen Ansprüche 1 bzw. 7 gelöst.

Durch die in den abhängigen Ansprüchen genannten Maßnahmen sind vorteilhafte Ausführungen und Weiterbildungen der Erfindung möglich.

Das erfindungsgemäße Verfahren dient zum Auslesen eines Demodulationspixels eines Entfernungssensors, der zur Bestimmung der Entfernung zu einem Objekt verwendet wird.

Insbesondere kann dabei auch die Differenz zweier Ladungsträgermengen unabhängig vom Gesamtbetrag der Ladungsmengen bestimmt werden. Im Zusammenhang mit einem Entfernungssensor kann es sich insbesondere anbieten, Demodulationspixels zum Empfang der Strahlung einzusetzen: Zunächst einmal wird die empfangene Strahlung in einem Umwandlungsbereich in photoinduzierte Ladungsträger umgesetzt. Diese Ladungsträger können zur weiteren Detektion und Verarbeitung aus dem entsprechenden Umwandlungsbereich, in der Regel dem Bulk-Bereich eines schwach dotierten Halbleitermaterials, abgezogen werden, etwa durch Anlegen einer Spannung. Diese Ladungsträger können abwechselnd, und zwar vorgegeben nach einer Modulationsfrequenz, in wenigstens zwei Ladungsträgermengen aufgeteilt werden. Über eine zeitliche Korrelation können somit auch Phaseneigenschaften des detektieren Lichts im Vergleich zum ursprünglich ausgesandten Lichtsignal bestimmt werden. Hierzu werden die aufgeteilten Ladungsträgermengen zunächst jeweils in einem Potentialtopf gefangen und gesammelt, wobei jeder Potentialtopf jeweils einzelnen Storagegates zugeordnet ist. Dieses Sammeln der Ladungsträger entspricht einer zeitlichen Integration. Eine Flanke eines solchen Potentialtopfs eines Storagegates wird durch ein sogenanntes Transfergate gebildet, das gewissermaßen als Schleuse zwischen dem Storagegate und einer Floating-Diffusion wirkt. Die Ladungsträgermenge kann in den jeweiligen Floating-Diffusions gemessen werden.

Im Unterschied zum Stand der Technik ist es gemäß der Erfindung vorgesehen, die Höhe des Potentialwalls, der durch das Transfergates ausgebildet wird, zu verändern, wozu eine variable Steuerspannung an die jeweiligen Transfergates angelegt wird. Es wird also nicht oder nicht ausschließlich, wie dies bislang im Stand der Technik vorgesehen war, die Potentialtopftiefe des Storagegates verringert, bis Ladungsträger den Potentialwall der jeweiligen Transfergates überwinden und zur Floating-Diffusion hinüberfließen können.

Erfindungsgemäß wird außer der Höhe des Potentialwalls des Transfergates auch die Topftiefe der entsprechenden Storagegates geändert.

Beide, nämlich die Höhe des Potentialwalls und die Topftiefe der Storagegates können gleichzeitig oder zu unterschiedlichen Zeiten verändert werden. Vorzugsweise kann zunächst die Höhe des Potentialwalls des Transfergates und dann die Topftiefe der Storagegates verändert werden.

Die Erfindung ermöglicht eine besonders wirksame Unterdrückung des dem eigentlichen Signal überlagerten Untergrundes.

Das erfindungsgemäße Verfahren ermöglicht es, optische Signale zu erfassen, die im Gegensatz zum Hintergrund, welcher die Signale überlagert, eine vergleichsweise geringe Intensität aufweisen. Hierbei werden Ladungsträger, die zum Beispiel von einem Photodetektor beim Empfang eines optischen Signals erzeugt werden, in z.B. zwei verschiedene Storagegates aufgeteilt.

Grundsätzlich ist es denkbar, das gleiche Signal parallel bzw. zeitgleich auf zwei unterschiedliche Kanäle aufzuteilen oder mit zwei verschiedenen Kanälen aufzunehmen. In diesem Fall kann unterstellt werden, dass in beiden Kanälen der gleiche Hintergrund überlagert ist. Im vorliegenden Fall wird das erfindungsgemäße Verfahren bei Entfernungssensoren angewandt, wobei das Signal aber in einer zeitlichen Abfolge aufgeteilt wird, d.h. zeitlich nacheinander werden die photoinduzierten Ladungsträger unterschiedlichen Sammeleinheiten (Storagegates) zugewiesen. Die jeweiligen Zeitspannen, in denen die Ladungsträger den jeweiligen Sammeleinheiten (Storagegates) zugewiesen werden, sind untereinander gleich lang.

Als Entfernungssensoren werden insbesondere sog. TOF-Sensoren (TOF: Time of Flight) eingesetzt. Bezüglich des Hintergrundes, der das eigentliche, die informationstragende Signal überlagert, kann regelmäßig davon ausgegangen werden, dass sich dieser mit der Zeit nur langsam ändert.

Die Aufteilung der Ladungsträger erfolgt ferner nach einer Modulationsfrequenz. Bei dieser Modulationsfrequenz handelt es sich auch um die Frequenz, die bei dem als TOF-Sensor arbeitenden Entfernungssensor dem ausgesandten Lichtsignal überlagert wird, um schließlich die Entfernung zu bestimmen. Beispielsweise wird ein im Vergleich zur Lichtfrequenz niederfrequentes Signal dem auszusendenden Lichtpuls überlagert, und es wird schließlich der Phasenunterschied bestimmt, der sich ergibt, wenn das Licht eine bestimmte Entfernung zu einem Objekt zurücklegt und das rückreflektierte Signal im Entfernungssensor detektiert wird.

Bei dem überlagerten Hintergrund kann es sich beispielsweise um ein Hintergrundlicht wie zum Beispiel das natürliche Tageslicht / Sonnenlicht oder das von einer in der Nähe befindlichen Lampe erzeugte Licht handeln (common-mode background). Auch der Dunkelstrom, etwa durch thermisch im Halbleitermaterial des Sensors erzeugte Ladungsträger, kann hierzu beitragen. Aus diesem Grunde kann auch davon ausgegangen werden, dass die Änderung dieses Lichts, wenn überhaupt, in weitaus größeren Zeitabständen erfolgt, zumindest im Vergleich zur Periodendauer der Modulationsfrequenz.

Es kann davon ausgegangen werden, dass die Differenz zweier Signale, bei denen in zeitlicher Abfolge photoinduzierte Ladungsträger gesammelt werden, dazu geeignet ist, den Hintergrund im Wesentlichen zu beseitigen. Typischerweise liegen nämlich die Integrationszeiten, in denen Ladungsträger in den Storagegates gesammelt werden, im Mikrosekunden oder Sub-Mikrosekundenbereich, während die Änderungen des Hintergrundes oftmals, wenn überhaupt nur im Stundenbereich zu erwarten sind. Außerdem erfolgen derartige Änderungen des Hintergrundlichts in der Regel allenfalls kontinuierlich und nicht abrupt.

Das erfindungsgemäße Verfahren ermöglicht eine sehr viel schnellere Signalverarbeitung, weil sehr viel geringere Kapazitäten zugesteuert werden müssen. Insbesondere ist es vorteilhaft, dass eine variable Steuerspannung am Transfergate angelegt werden kann und somit die Höhe des Potentialwalls beeinflussbar ist: Bei herkömmlichen Verfahren nach dem Stand der Technik musste der zur Verfügung gestellte Potentialwall des Transfergeräts eine endliche Höhe besitzen, welche konstant gehalten wurde, damit dann, wenn die Topftiefe der jeweiligen Storagegates verringert wird, auch die Möglichkeit besteht, dass die Ladungsträger diesen Potentialwall des jeweiligen Transfergeräts überwinden, um schließlich in einen Detektionsbereich (Floating-Diffusion) zu gelangen. Ist das Niveau jedoch erreicht, an dem Ladungsträger den Potentialwall überwinden können, so hat es sich bei herkömmlichen Sensoren nach dem Stand der Technik bislang als schwierig herausgestellt, den Fluss der Ladungsträger über den Potentialwall allein dadurch ohne Verzögerung zu stoppen, dass die Topftiefe des jeweiligen Storagegates nicht mehr geändert und konstant gehalten wurde. Dieser nachteilige Effekt wird erfindungsgemäß jedoch dadurch beseitigt, dass die Höhe des Potentialwalls angehoben wird, sodass wieder eine Barriere zwischen Storagegate und Floating-Diffusion entsteht. Der Ladungstransfer zwischen Storagegate und Floating-Diffusion wird also erfindungsgemäß besonders effektiv gestoppt.

Hierdurch kann auch die Genauigkeit des Messverfahrens verbessert werden.

Darüber hinaus zeichnet sich das erfindungsgemäße Verfahren dadurch aus, dass es einfach implementiert werden kann und auch keine grundsätzlichen Änderungen zu bislang verwendetem Detektorlayout erfordert.

Das Stoppen der Passage der Ladungsträger zur jeweils zugeordneten Floating-Diffusion erfolgt dann, sobald aus zwei der Storagegates jeweils Ladungsträger entsprechend passieren. Aus dem Storagegate, in dem eine größere Ladungsträgermenge angehäuft ist, werden zuerst Ladungsträger zur entsprechenden Floating-Diffusion passieren können, weil in diesem Fall der Potentialwall des Transfergates schneller überwunden werden kann. Wird der Potentialwall weiter erniedrigt bzw. die Topftiefe der Storagegates verringert, so werden zu einem späteren Zeitpunkt Ladungsträger des entsprechenden anderen Storagegates ebenfalls zur Floating-Diffusion passieren können. Jetzt zu diesem Zeitpunkt kann die Potentialdifferenz der beiden Floating-Diffusions bestimmt werden, woraus sich die Differenz der Ladungsträgermengen ergibt. In vorteilhafter Weise kann diese Bestimmung auch unabhängig vom Gesamtbetrag der Ladungsträgermengen erfolgen, d.h. es kann weitgehend unberücksichtigt bleiben, wie stark die Hintergrundstrahlung ist, ohne dass das die eigentliche Information tragende Signal vorher verstärkt werden müsste.

Um, wie bereits oben dargestellt, ein besonders effektives Stoppen der Ladungsträgerpassage erreichen zu können, wird der Potentialwall zwischen Storage-Gate und Floating-Diffusion wieder erfindungsgemäß erhöht, sodass der Übergang der Ladungsträger vom Potentialtopf des Storagegates zur Floating-Diffusion praktisch verhindert werden kann, da sonst bei aus dem Stand der Technik bekannten Sensoren weiter Ladungsträger zur Floating-Diffusion gelangen, auch wenn die Topftiefe des Storagegates bzw. die an das Storagegate angelegte Steuerspannung nicht mehr geändert wird.

Es kann sich bei einem Ausführungsbeispiel als besonders vorteilhaft erweisen, dass in dem Zustand, in dem die Ladungsträger im Potentialtopf eines Storagegates gefangen sind, der Potentialwall des Transfergates sehr hoch ist, um ein effektives Stoppen der Ladungsträger bzw. Zurückhalten der Ladungsträger im Potentialtopf zu ermöglichen. In diesem Zustand wird die Topftiefe des Storagegates bzw. die Steuerspannung des Storagegates gar nicht erst so stark variiert, dass die Ladungsträger auf das Niveau des sehr viel höheren Potentialwalls des Transfergates gehoben werden. Erst dann, wenn die Ladungsträger zur Floating-Diffusion übergehen sollen, wird die Höhe des Potentialwalls abgesenkt.

Es sind grundsätzlich Ausführungsvarianten der Erfindung denkbar, bei denen die Änderung der Steuerspannung am Transfergate und/oder am Storagegate stetig oder in Sprüngen vorgenommen wird. Wenn die Ladungsträger, die im Storagegate gesammelt sind, kaum noch von der Oberkante des Potentialwalls am Transfergate entfernt sind, sodass ein Hinüberfließen zur Floating-Diffusion bald zu erwarten ist, ist es in der Regel vorteilhaft, aus Genauigkeitsgründen die entsprechende Steuerspannung kontinuierlich bzw. stetig zu ändern, damit der Punkt, an dem dieses Hinüberfließen zur Floating-Diffusion möglich wird, nicht verpasst bzw. übersprungen wird. Grundsätzlich handelt es sich bei der entsprechenden Steuerspannung um die Spannung, die dafür sorgt, dass die Ladungsträger im Storagegate das entsprechende Niveau im Vergleich zur Potentialwallhöhe erreichen, d.h. es handelt sich dabei um die Steuerspannung am Storagegate und/oder am Tranfergate.

Die Bestimmung der Potentialdifferenz in den Floating-Diffusions kann grundsätzlich zu verschiedenen Zeitpunkten erfolgen, nämlich:
- gerade zu dem Zeitpunkt, wenn Ladungsträger aus den (beiden) entsprechenden Storagegates zu den jeweiligen Floating-Diffusions übertreten,
- gerade zu dem Zeitpunkt, wenn noch aus beiden Potentialtöpfen der Storagegates Ladungsträger übertreten, d.h. kurz bevor die Ladungsträgermengen in beiden Potentialtöpfen erschöpft sind, bzw.
- während der Zeitspanne zwischen den beiden zuvor genannten Zeitpunkten.

Alle drei Optionen können grundsätzlich verwendet werden. Je nachdem, welche der drei Optionen gewählt wird, kann es vorteilhaft sein, das Potential der entsprechenden Floating-Diffusion in Bezug auf einen jeweils anderen Referenzwert zu bestimmen. Wenn die Potentiale der jeweiligen Floating-Diffusions zu gleichen Zeitpunkten bestimmt werden, um deren Differenz zu messen, können diese Potentialwerte grundsätzlich zum gleichen Referenzwert gemessen werden. Hierzu kann bei einem Ausführungsbeispiel eine Vergleichsvorrichtung vorgesehen sein, die das gemessene Potential mit einem Referenzwert vergleicht, d.h. es ist zum Beispiel ein Operationsverstärker (Komparator) vorgesehen, der zum einen mit dem Referenzwert-Potential und zum anderen mit dem Potential der entsprechenden Floating-Diffusion beschaltet ist. Bei dieser Art von Schaltung ergibt sich in vorteilhafter Weise, dass die Signale anschließend (ab dem Ausgang des Operationsverstärkers) in digitaler Form vorliegen und entsprechend mit einer Schaltungslogik ausgewertet werden können. Werden die Potentiale zum Beispiel jedoch zu unterschiedlichen Zeitpunkten bestimmt, können grundsätzlich auch verschiedene Referenzwerte verwendet werden.

Es wurde bereits dargestellt, dass es grundsätzlich verschiedene Möglichkeiten gibt, die jeweils gesammelten Ladungsträgermengen in den Bereich der Oberkante des Potentialwalls zu bringen, sodass ein Hinüberfließen der Ladungsträger zur jeweiligen Floating-Diffusion ermöglicht wird: Zum einen kann zu diesem Zweck die Höhe des Potentialwalls herabgesetzt werden, während zum anderen auch die Tiefe des Potentialtopf verringert werden kann. Hierzu ist jeweils eine Steuerspannung, die in einen Fall an das Transfergate und im anderen Fall an das Storagegate angelegt wird, zu verändern.

Bei einer bevorzugten Weiterbildung der Erfindung wird zunächst die Höhe des Potentialwalls des Transfergates beeinflusst bzw. verringert. Wenn noch keine Ladungsträger während der Absenkung des Potentialwalls zur Floating-Diffusion geflossen sind, wird diese Absenkung des Potentialwalls zu einem vorgegebenen Zeitpunkt bzw. bei einer vorgegebenen Höhe des Potentialwalls (etwa bei der Hälfte der maximalen Topftiefe am Storagegate) gestoppt, wobei anschließend die Tiefe des Potentialtopf des Storagegates verringert wird (hierzu wird das Potential des Storagegates bei der vorliegenden Beschaltung abgesenkt). Dies geschieht zumindest so lange, bis entsprechend jeweils Ladungsträger den Potentialwall überwinden können. Grundsätzlich ist es aber auch denkbar, gleichzeitig die Höhe des Potentialwalls und die Tiefe des Potentialtopf zu variieren, indem die Steuerspannungen des Transfergates und des Storagegates gleichzeitig variiert werden.

Bei der bevorzugten Ausführungsform, bei der die entsprechenden Gates nacheinander variiert werden, kann der Vorteil hinsichtlich der Steuerung darin bestehen, dass die Änderung des Potentialwalls nicht abrupt in ihrem zeitlichen Verlauf das Vorzeichen ändern muss. Um ein Herüberfließen der Ladungsträger zur Floating-Diffusion zu ermöglichen, müsste sonst das Potential des Potentialwalls zunächst herabgesenkt werden und, um diese Passage wieder zu stoppen, müsste es unmittelbar im Anschluss daran wieder erhöht werden. Dieser Vorzeichenwechsel müsste vergleichsweise abrupt erfolgen. Es ist daher vorteilhaft, wenn dieser letzte Abschnitt, bevor die Ladungsträger den Potentialwall überschreiten, durch eine Veränderung der Steuerspannung des Storagegates bewirkt wird, d.h. die Tiefe des Potentialtopf wird herabgesetzt. Der Vollständigkeit halber sei erwähnt, dass etwaige Tunneleffekte, wonach ein Tunneln von Ladungsträgern durch eine Barriere quantenmechanisch möglich ist, im vorliegenden Fall nicht oder nur bedingt betrachtet werden.

Um eine effektive Trennung der Ladungsträger, insbesondere nach der Modulationsfrequenz, zu ermöglichen, kann ein entsprechender Trennbereich vorgesehen sein. Eine möglichst effektive Umwandlung der einfallende Photonen des zu detektieren optischen Signals in photoinduzierte Ladungsträger kann vorteilhafter Weise in einem großen Umwandlungsbereich mit ausreichender Dicke für tief ins Material eindringende Photonen vorgesehen sein. Im Falle eines Halbleiterdetektors ist zum Beispiel ein großer Bereich des Bulk-Materials als Umwandlungsbereich vorgesehen, etwa ein schwach dotierter Bereich. Dieser Bereich ermöglicht auch bei großer Eindringtiefe der Photonen eine effektive Umwandlung in Ladungsträger.

Die Auftrennung erfolgt aber in effektiver Weise nicht in dem gesamten, vergleichsweise großen Umwandlungsbereich, sondern die Ladungsträger werden von dort abgezogen und einem Trennbereich zugeführt. Dies kann vorteilhafter Weise durch Anlegen einer Spannung erfolgen, wozu insbesondere ein sogenanntes Driftgate vorgesehen ist. Somit kann mit geringeren Steuerspannungen eine effektivere Auftrennung auf kleinerem Bauraum erfolgen. Insgesamt kann der Sensor somit auch sehr kompakt gestaltet sein.

Dementsprechend zeichnet sich ein erfindungsgemäßer Entfernungssensor dadurch aus, dass die Transfergates dazu ausgebildet sind, die von ihnen jeweils erzeugten Potentialwälle hinsichtlich ihrer Höhe zu verändern, wobei ferner eine Vergleichsvorrichtung vorgesehen ist, um ein Absenken der jeweiligen Potentialwälle durchzuführen, bevor aus zwei Storagegates jeweils Ladungsträger den jeweiligen Potentialwall überwinden und zur entsprechenden Floating-Diffusion herüberfließen können. Durch diesen erfindungsgemäßen Entfernungssensor können die bereits zuvor beschriebenen Vorteile erzielt werden. Insbesondere ist ein effektives Stoppen der Passage der Ladungsträger möglich, sodass insgesamt die Signalverarbeitungszeiten verringert und die Genauigkeit erhöht werden kann.

In besonders vorteilhafter Weise ermöglicht eine Ausführungsform der Erfindung auch eine besonders kompakte Bauweise. Grundsätzlich ist es möglich, jedem Demodulationspixel genau eine Vergleichsvorrichtung zuzuordnen, welche die Potentiale der darin angeordneten Floating-Diffusions bestimmt bzw. vergleicht. Es ist aber auch möglich, mehreren Demodulationspixels eine gemeinsame Vergleichsvorrichtung zuzuordnen. Insbesondere lässt sich eine Anordnung innerhalb einer Matrix aus Demodulationspixels bei einem Entfernungssensor gemäß der Erfindung so ausbilden, dass diese nach Zeilen und Spalten ausgelesen werden kann. Durch die Festlegung auf eine Zeile und eine Spalte erfolgt eine eineindeutige Zuordnung zu einem bestimmten Pixel. Das Auswertungsergebnis der gemeinsamen Vergleichsvorrichtung kann also genau diesen Pixel zugeordnet werden. Eine solche Bauart kann noch platzsparender und kompakter, sowie des Weiteren mit geringerem Kostenaufwand realisiert werden.

Grundsätzlich ist es denkbar, ein Demodulationspixel auszubilden, bei dem eine Auftrennung der Ladungsträger in zwei Teilmengen erfolgt. Denkbar ist es aber auch, dass nach der Modulationsfrequenz eine Aufteilung in zum Beispiel vier Teile vorgenommen wird. Dementsprechend können sodann auch entsprechend mehr Storagegates, Transfergates, Floating-Diffusions vorgesehen sein.

### Ausführungsbeispiele

Ausführungsbeispiele der Erfindung sind in den Zeichnungen dargestellt und werden nachstehend unter Angabe weiterer Einzelheiten und Vorteile näher erläutert. Im Einzelnen zeigen:
- Figuren 1-12:: eine schematische Darstellung des Auslesevorgangs eines Demodulationspixels gem. der Erfindung, sowie
- Figuren 13- 14:: eine Matrixanordnung von Pixeln in einem Entfernungssensor gem. der Erfindung.

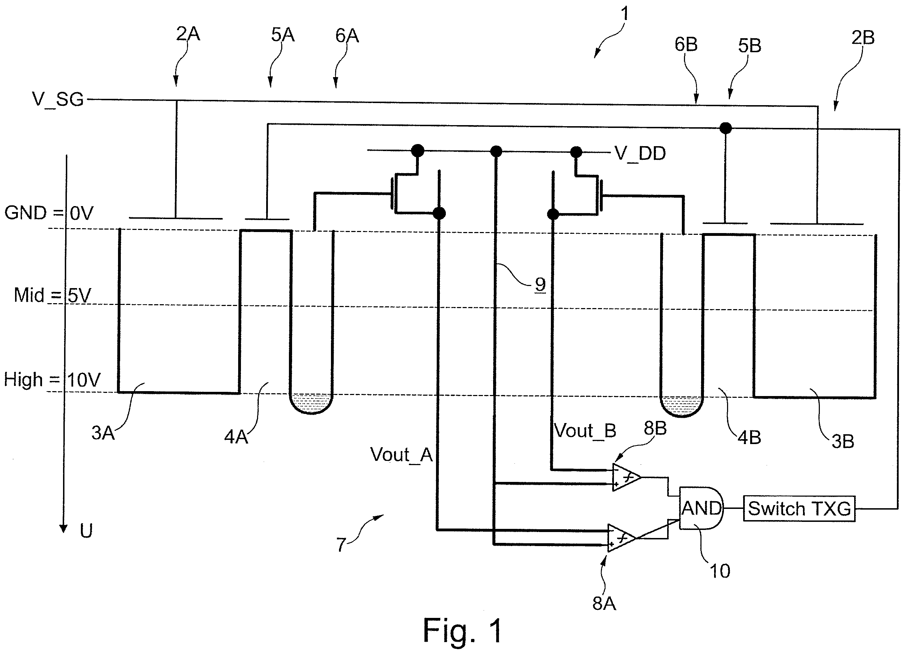

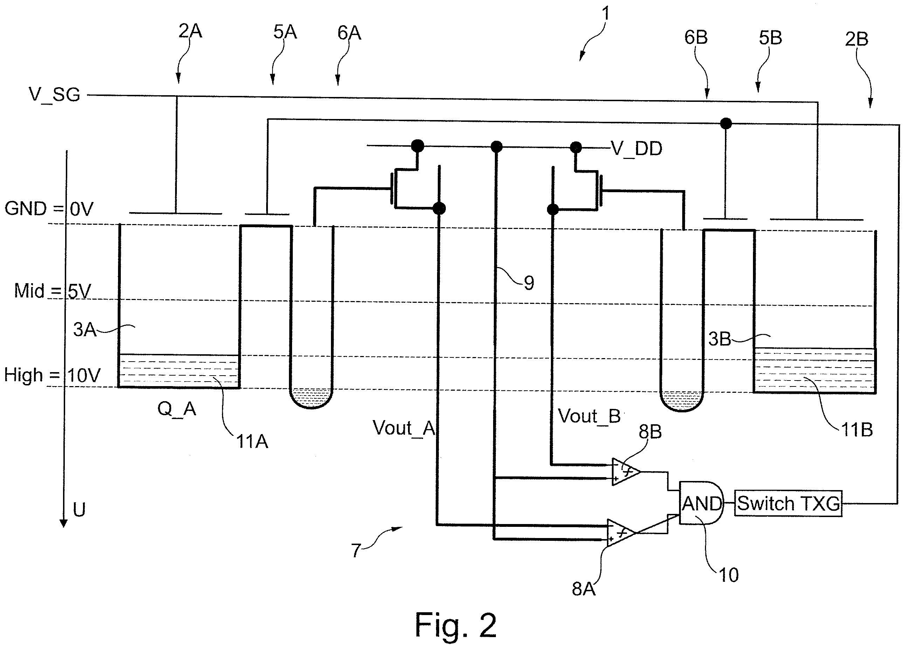

Figur 1 zeigt eine schematische Darstellung eines Demodulationspixels 1. Der Umwandlungsbereich, in dem die photoinduzierten Ladungsträger durch Photonen eines zu detektierenden Signals erzeugt werden, sowie die eigentliche Halbleitertopographie, sind nicht im Einzelnen dargestellt. Die photoinduzierten Ladungsträger werden nach einer Modulationsfrequenz aufgetrennt in zwei Ladungsträgermengen die jeweils über ein gewisses Zeitintervall in den Storagegates 2A, 2B gesammelt werden. Hierzu sind bei den Storagegates 2A, 2B jeweils Potentialtöpfe 3A, 3B ausgebildet. Das Sammeln von Ladungsträgern ist in Figur 2 dargestellt.

In der Regel liegen die beiden Storagegates 2A, 2B in der tatsächlich gewählten Halbleitertopographie jeweils unmittelbar neben einem Driftgate, in dessen Bereich die Ladungsträger aus dem Umwandlungsbereich geführt werden. Zur besseren Übersicht wurde in der Darstellung der Figuren jedoch eine andere Reihenfolge gewählt.

Eine Wand des Potentialtopfs 3A bzw. 3B bildet der Potentialwall 4A bzw. 4B, der wiederum durch das Transfergate 5A, 5B erzeugt wird. An den jeweiligen Transfergates 5A, 5B liegt eine variable Steuerspannung an. Die Potentialwalle 4A, 4B trennen die Potentialtöpfe 3A, 3B von der Floating-Diffusion 6A, 6B, wobei die Floating-Diffusions 6A, 6B jeweils eine Potentialmessung bzw. eine Bestimmung der zu ihnen herübergeflossenen Ladungsträgermengen ermöglichen.

Darüber hinaus umfasst das in Figur 1 dargestellte Demodulationspixel eine Vergleichsvorrichtung 7. Hierzu sind die beiden Floating-Diffusions 6A, 6B jeweils an einen Eingang eines Operationsverstärker 8A, 8B angeschlossen. Diese beiden Operationsverstärker 8A, 8B vergleichen den anliegenden Spannungswert gegenüber einem Referenzpotential, das über die Leitung 9 als gemeinsames Potential an beiden Operationsverstärker 8A, 8B angeschlossen ist. Die Operationsverstärker 8A, 8B vergleichen also das jeweilige Potential der Floating-Diffusion 6A bzw. 6B mit einem entsprechenden gemeinsamen Referenzpotential (Referenzwert) und liefern einen digitalen Ausgang "1", wenn dieser Referenzwert überschritten wird bzw. den Wert "0", wenn der Referenzwert nicht erreicht wird. Über ein UND-Gatter 10 wird dann der Moment festgestellt, wenn beide gemessenen Potentiale der Floating Diffusion 6A, 6B diesen Referenzwert übersteigen, d.h. es fließen aus beiden Potentialtöpfen 3A, 3B Ladungsträger über die jeweiligen Potentialwälle 4A, 4B zur entsprechenden Floating Diffusion 6A, 6B. Die anliegenden Spannungen sind so gewählt, dass die Potentialwälle 4A, 4B im vorliegenden Fall auf Masse, d.h. bei 0 V liegen. Die beiden Potentialtöpfe 3A, 3B liegen im vorliegenden Fall auf +10 V. Wird also das Potential der jeweiligen Potentialtöpfe 3A, 3B gesenkt, so verringert sich auch die Höhe der entsprechenden Potentialtöpfe 3A, 3B, d.h. der "Boden" der Potentialtöpfe 3A, 3B wird in der Darstellung der Figur 1 angehoben. Die Potentiale der Floating-Diffusion 6A, 6B liegen auf einem gegenüber den Potentialtöpfen 3A, 3B höheren Potential, sodass Ladungsträger auch tendenziell eher zu den Floating-Diffusions 6A, 6B fließen können. Ebenfalls dargestellt ist ein mittlerer Potentialwert von +5 V.

Die Darstellung nach Figur 2 unterscheidet sich lediglich dadurch von der gemäß Figur 1, dass in den Potentialtöpfen 3A, 3B Ladungsträgermengen 11A, 11B gesammelt sind. Das bedeutet, dass nach einer vorgegebenen Modulationsfrequenz abwechselnd Ladungsträger jeweils in das Storagegate 2A bzw. 2B geleitet werden.

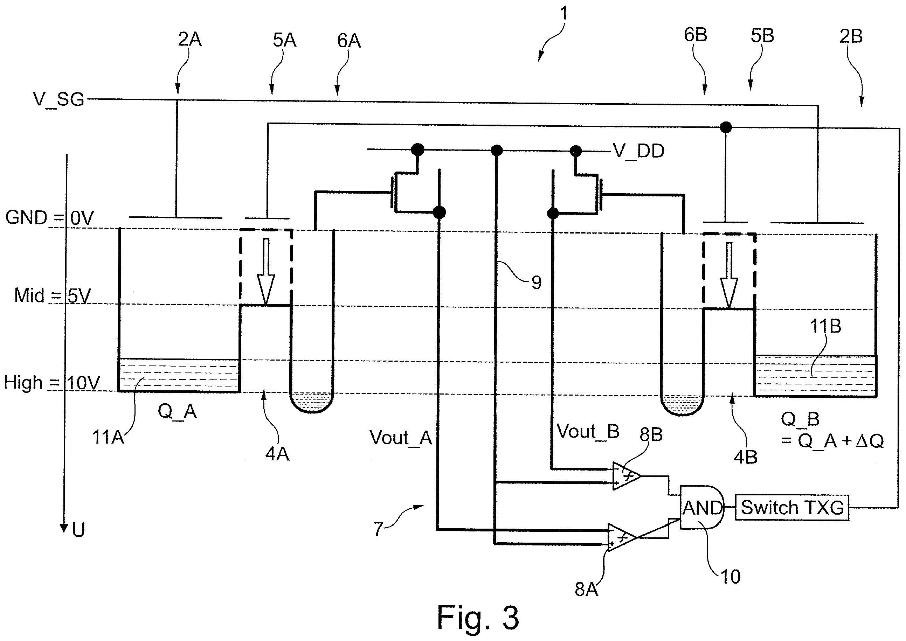

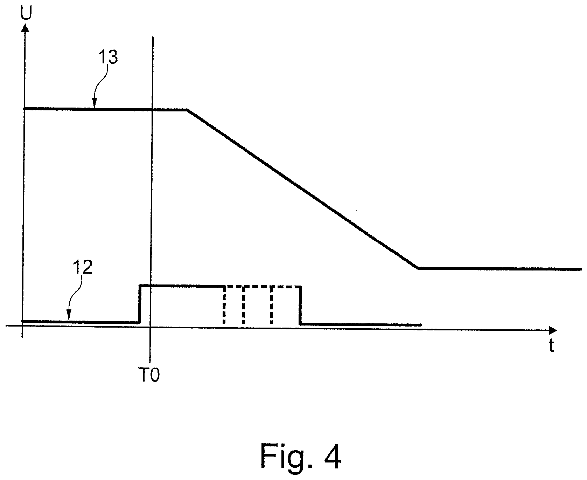

Zum Auslesen des Demodulationspixels werden gemäß der Darstellung nach Figur 3 nunmehr die Potentialwälle 4A, 4B abgesenkt. Im übrigen ist zu sehen, dass die Ladungsträgermenge 11A kleiner ist als die Ladungsträgermenge 11B. Der Potentialverlauf ist im Diagramm nach Figur 4 dargestellt, wobei das Potential bzw. die angelegte Steuerspannung auf der Achse U und die Zeit auf der Achse t aufgetragen sind. Die Spannung am Transfergate 5A, 5B wurde jeweils gleichzeitig erhöht bzw. die Höhe der entsprechenden Potentialwälle 4A, 4B erniedrigt, was im Diagramm gemäß Figur 4 durch einen sprunghaften Anstieg der Kurve 12 zum Zeitpunkt T0 gezeigt ist. Die Spannung an den Storagegates 2A, 2B, dargestellt in der Kurve 13, bleibt bis zu diesem Zeitpunkt t0 konstant.

Die Potentialwälle 4A, 4B werden sprunghaft herabgesenkt, sodass ein Potentialwert von +5 V erreicht wird. Bis dahin sind im vorliegenden Fall keine Ladungsträger aus dem Potentialtopf 3A oder 3B über die entsprechenden Potentialwälle 4A, 4B hinweg zur jeweiligen Floating-Diffusion 6A, 6B geflossen.

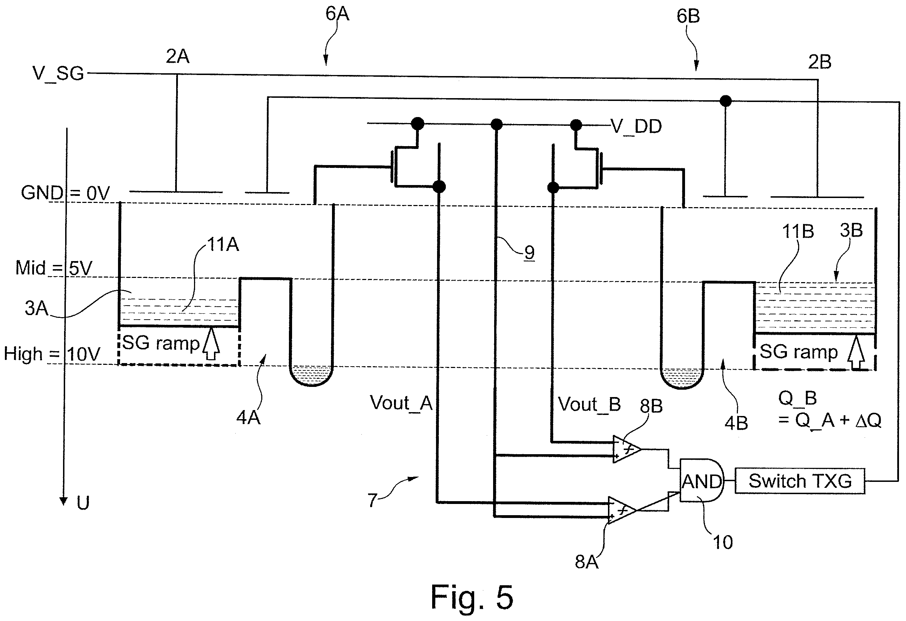

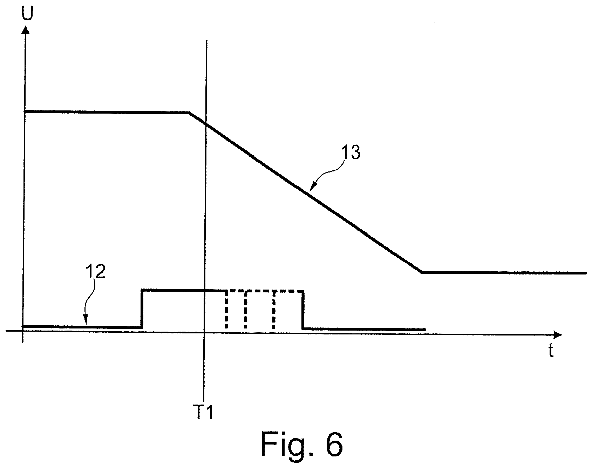

Nun wird im Anschluss daran zum Zeitpunkt T1 die Tiefe der Potentialtöpfe 3A, 3B verkleinert (Figur 5), indem das Potential der jeweiligen Storagegates 2A, 2B ebenfalls gesenkt wird. Die entsprechende Herabsetzung des Potentials der Storagegates 2A, 2B ist in der Kurve 13 aus Figur 6 dargestellt. Wie ebenfalls zu sehen ist, bleibt das Potential der Kurve 12 zu diesem Zeitpunkt noch konstant, d.h. die Höhe der Potentialwälle 4A, 4B ändert sich vorerst nicht.

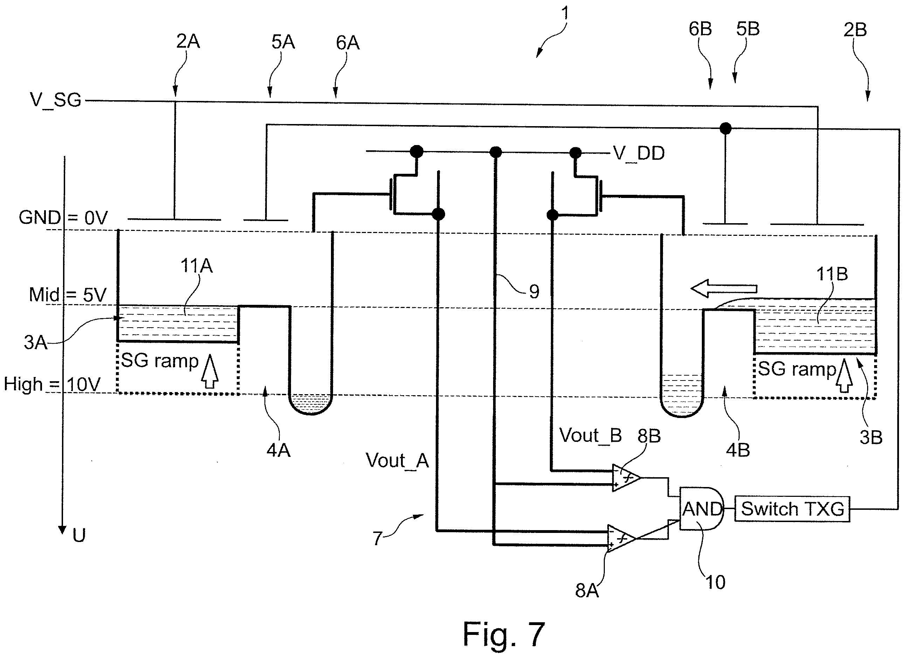

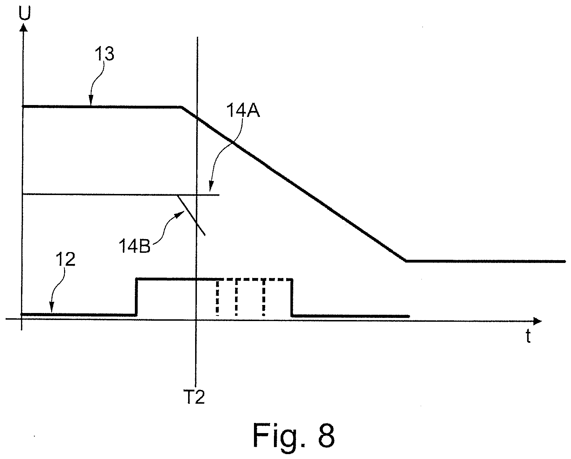

In Figur 7 wiederum ist dargestellt, bei dem zum ersten Mal Ladungsträger aus der Ladungsträgermenge 11B in Richtung Floating-Diffusion 6B herüberfließen. Dies ist bei der Ladungsträgermenge 11B, die größer ist als die Ladungsträgermenge 11A im zeitlichen Verlauf somit früher der Fall. In Figur 8 sind zusätzlich die beiden Verläufe 14A, 14B der Floating-Diffusion 6A, 6B gezeigt, wobei entsprechend der Verlauf 14A konstant bleibt, während bei der Kurve 14B zum Zeitpunkt T2 ein Potentialeinbruch zu verzeichnen ist. Je mehr Ladungsträger aus einem der Potentialtöpfe 3A, 3B in die entsprechende Floating-Diffusion 6A, 6B herüberfließen, desto geringer wird das entsprechende Potential der Floating-Diffusion 6A, 6B.

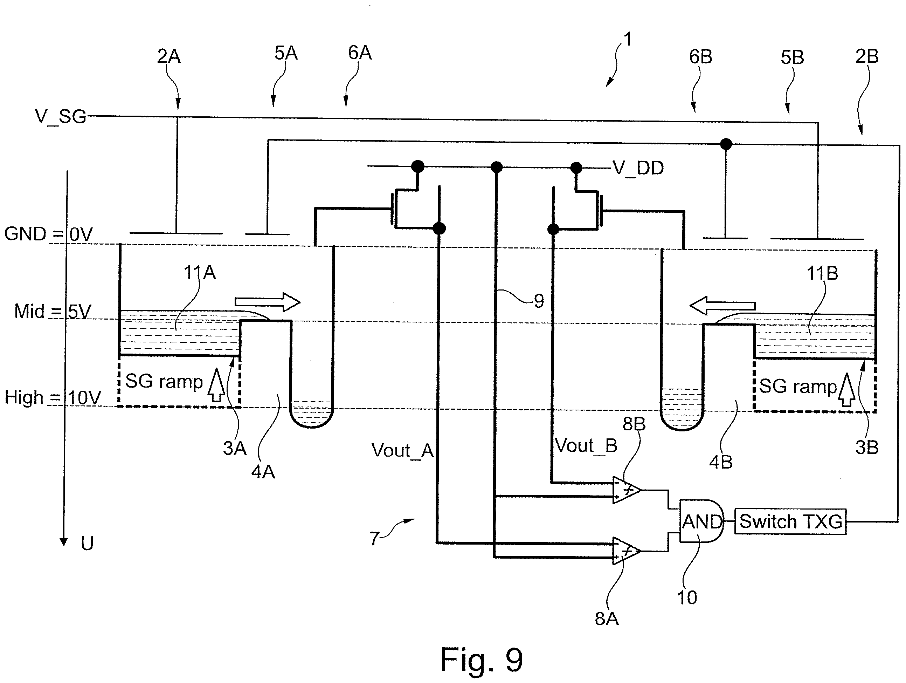

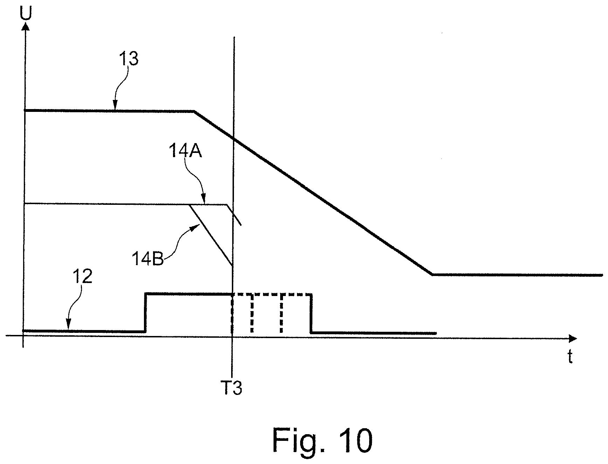

In den Figuren 9, 10 ist genau der Zeitpunkt T3 beschrieben, an dem aus beiden Potentialtöpfe 3A, 3B Ladungsträger zur jeweiligen Floating-Diffusion 6A, 6B hinüberfließen. In Figur 10 erhält die Potentialkurve 14A zu diesem Zeitpunkt T3 ebenfalls einen Knick, d.h. das Potential wird erniedrigt.

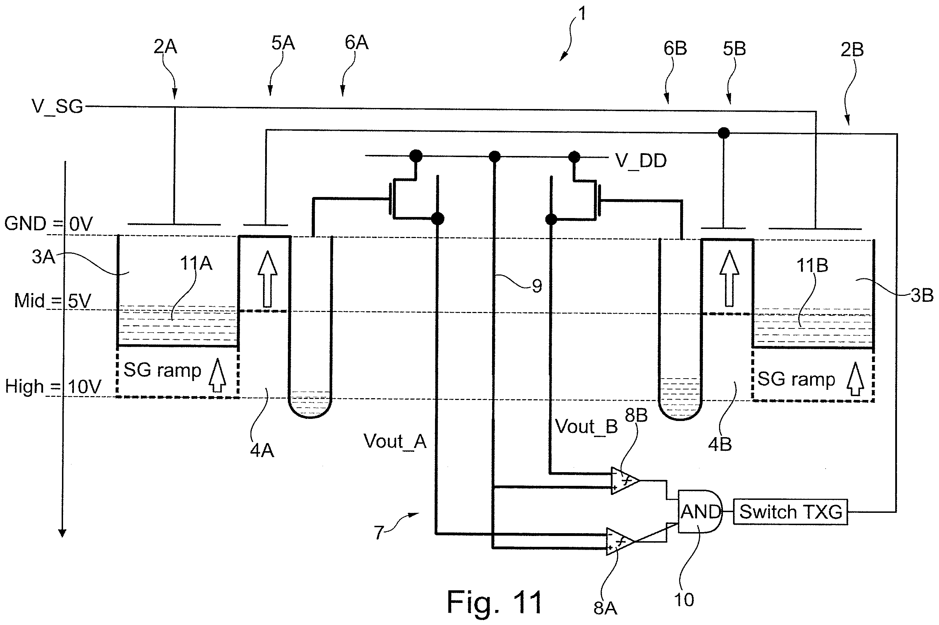

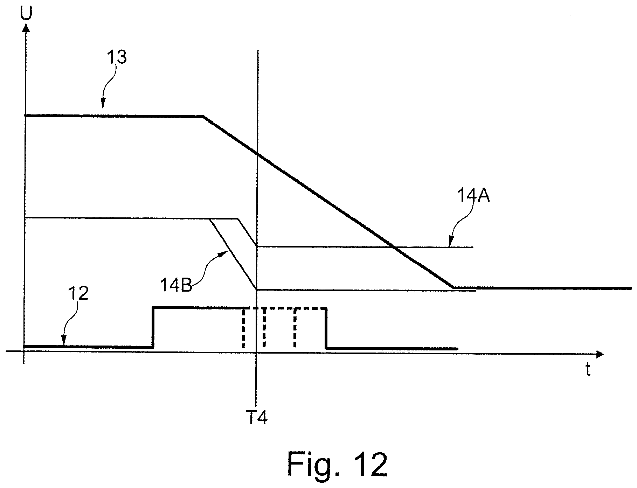

Um diesen Ladungsträgerfluss zu stoppen, wird gemäß den Figuren 11, 12 die Höhe der Potentialwälle 4A, 4B wiederum erhöht, d.h. das Potential der entsprechenden Transfergates 5A, 5B wird wieder auf 0 V herabgesenkt. Dies geschieht zum Zeitpunkt T4. Nun kann auch die Potentialdifferenz der beiden Floating-Diffusions 6A, 6B bestimmt werden. Eine weitere Änderung der Steuerspannung (storage-gate ramping) ändert, solange diese gering gegenüber der abrupten Änderung der Steuerspannung am Transfergate, nichts mehr daran, dass das Herüberfließen der Ladungsträger zur Floating-Diffusion gestoppt ist, weil hier der durch das Transfergate aufgebaute Potentialwall deutlich zu hoch ist.

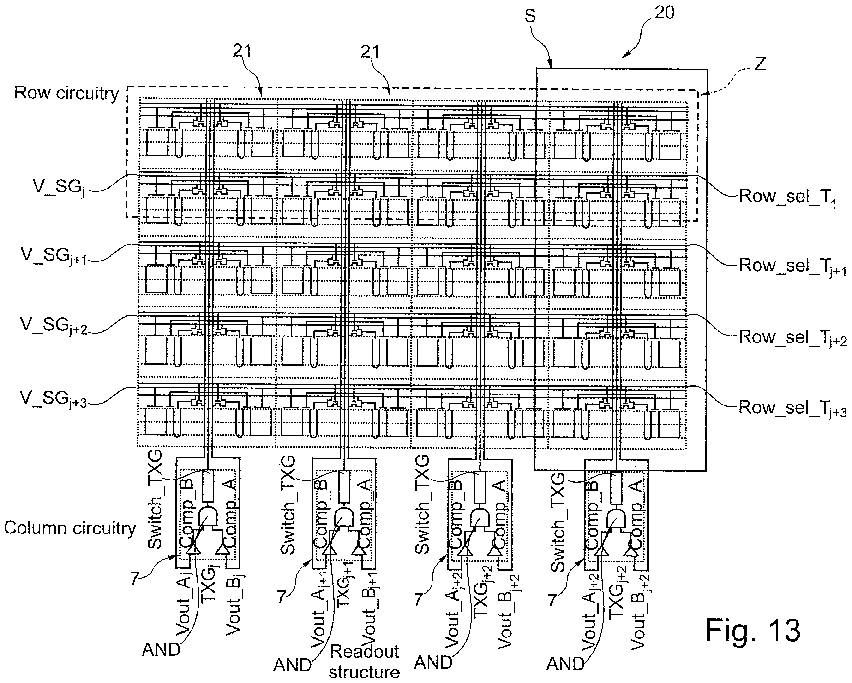

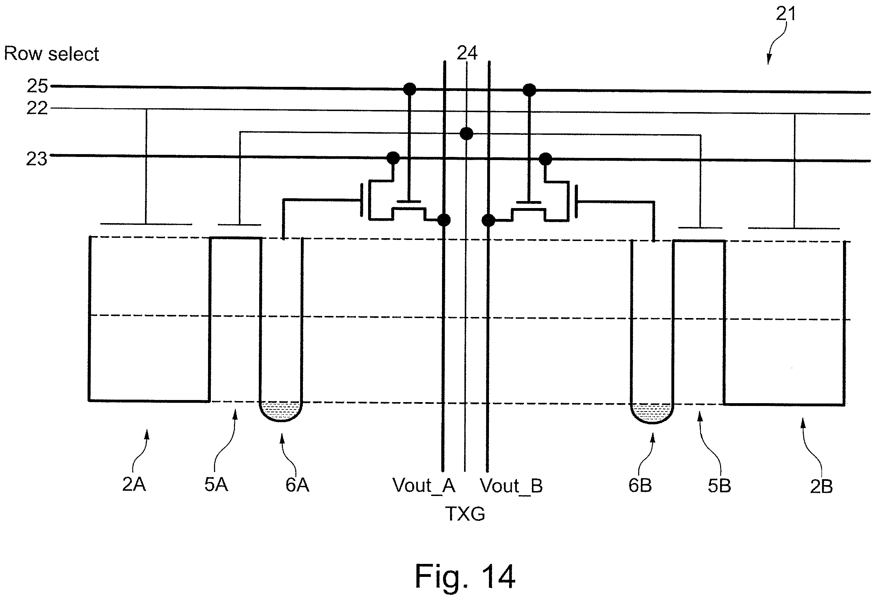

Figur 13 wiederum zeigt einen Entfernungssensor bzw. eine Matrixanordnung 20 von Demodulationspixeln 21. Eine vergrößerte Darstellung der Beschaltung eines Demodulationspixels ist in Figur 14 dargestellt. Die Anordnung 20 verläuft in Zeilen Z und Spalten S. Wie aus den Figuren 13, 14 hervorgeht, sind zeilenweise für jedes Demodulationspixel einer Zeile Z gemeinsame Leitungen für die Storagegates 2A, 2B (Leitung 22) und für das Referenzpotential (Leitung 23) vorgesehen. Spaltenweise wiederum ist eine gemeinsame Leitung 24 vorgesehen, um die variable Steuerspannung an die Transfergates 5A, 5B einer jeweiligen Spalte S anzulegen. Das Auslesen der Matrix 20 erfolgt zeilen- und spaltenweise, wobei die Festlegung auf eine bestimmte Zeile Z bzw. Spalte S ein bestimmtes Demodulationspixel 21 automatisch festlegt.

Die Auswahl der Zeilen Z erfolgt über eine Zeilenauswahl-Leitung 25; das Anwählen dieser Leitung 25 sorgt dafür, dass die jeweiligen Floating-Diffusions 6A, 6B ausgelesen werden. Das Ansteuern einer Leitung 24 wiederum bewirkt, dass das Potential der Transfergates 5A, 5B einer Spalte S variiert werden kann. Dementsprechend genügt es, pro Spalte S eine Vergleichsvorrichtung 7 vorzusehen.

Allen Ausführungsbeispielen und Weiterbildungen der Erfindung ist gemeinsam, dass an die Transfergates eine variable Steuerspannung angelegt werden kann; es erfolgt ein Absenken der jeweiligen Potentialwälle der entsprechenden Transfergates, bevor und/oder bis aus zwei der Storagegates jeweils Ladungsträger den jeweiligen Potentialwall des entsprechenden Transfergates überwinden und zur zugeordneten Floating-Diffusion passieren können. Insbesondere kann das Stoppen des Ladungsträgerflusses zur Floating-Diffusion abrupter und effektiver gestoppt werden. Insgesamt kann zudem die Signalverarbeitungszeit reduziert werden.

Bezugszeichen:
- 1: Demodulationspixel
- 2A, 2B: Storagegate
- 3A, 3B: Potentialtopf des Storagegate
- 4A, 4B: Potentialwall
- 5A, 5B: Transfergate
- 6A, 6B: Floating-Diffusion
- 7: Vergleichsvorrichtung
- 8A, 8B: Operationsverstärker / Komparator
- 9: Leitung für Referenzpotential
- 10: UND-Gatter
- 11A, 11B: Ladungsträgermenge
- 12: Steuerspannung an Transfergates
- 13: Steuerspannung an Storagegates
- 14A, 14B: Potential an Floating-Diffusion
- 20: Matrixanordnung in Entfernungssensor
- 21: Demodulationspixel
- 22: Leitung für Storagegates
- 23: Leitung für Transfergates
- 24: Leitung für Referenzpotential
- 25:
- T0: Zeitpunkt (Verringern der Potentialwallhöhe an den Transfergates)
- T1: Zeitpunkt (Verringern der Topftiefe an den Storagegates)
- T2: Zeitpunkt (erstes Hinüberfließen zu einer Floating-Diffusion)
- T3: Zeitpunkt (zweites Hinüberfließen zu einer Floating-Diffusion)
- T4: Zeitpunkt (Vergrößern der Potentialwallhöhe an den Transfergates)
- t: Zeitachse
- U: Achse für Spannung / Potential
- S: Spalte
- Z: Zeile

## Patentansprüche

1. Verfahren zum Auslesen eines Demodulationspixels (1, 21) eines Entfernungssensors (20) zur Bestimmung der Entfernung zu einem Objekt, zur Bestimmung der Differenz zweier Ladungsmengen (11A, 11B) unabhängig vom Gesamtbetrag der Ladungsmengen (11A, 11B), umfassend folgende Verfahrensschritte:
• Bereitstellen eines Demodulationspixels (1, 21) zum Empfang von Strahlung,
• Umwandeln der empfangenen Strahlung in einem Umwandlungsbereich in photoinduzierte Ladungsträger,
• Trennen der Ladungsträger nach einer Modulationsfrequenz in wenigstens zwei Ladungsträgermengen,
• Sammeln der aufgetrennten Ladungsträgermengen jeweils im Potentialtopf (3A, 3B) eines von wenigstens zwei Storagegates (2A, 2B), welche jeweils den Ladungsträgermengen (11A, 11B) zugeordnet sind,
• Abschotten der wenigstens zwei Storagegates (2A, 2B)durch jeweils einen Potentialwall (4A, 4B) eines jedem der Storagegates (2A, 2B) zugeordneten Transfergates (5A, 5B) als Schleuse für die im zugeordneten Storagegate (2A, 2B) gesammelten Ladungsträger von jeweils einer zugeordneten Floating-Diffusion (6A, 6B) zur Aufnahme der vom jeweiligen Transfergate (5A, 5B) weitergeleiteten Ladungsträger und zur Einspeisung der Ladungsträger als Spannung in einen Auswertebereich, umfassend:
• Anlegen einer variablen Steuerspannung an die Transfergates (5A, 5B) zur Beeinflussung des Potentialwalls (4A, 4B)und
• Absenken der jeweiligen Potentialwälle (4A, 4B) der entsprechenden Transfergates (5A, 5B), bevor aus den Storagegates (2A, 2B) jeweils Ladungsträger den jeweiligen Potentialwall (4A, 4B) des entsprechenden Transfergates (5A, 5B) überwinden und zur zugeordneten Floating-Diffusion (6A, 6B) passieren können, wobei die Topftiefe des entsprechenden Potentialtopfes (3A, 3B) des zugeordneten Storagegates (2A, 2B) verringert wird, bis aus zwei der Storagegates (2A, 2B) jeweils Ladungsträger den jeweiligen Potentialwall (4A, 4B) des entsprechenden Transfergates (5A, 5B) überwinden und zur zugeordneten Floating-Diffusion (6A, 6B) passieren können.
**dadurch gekennzeichnet, dass** das Stoppen der Passage der Ladungsträger zur jeweils zugeordneten Floating-Diffusion (6A, 6B) erfolgt, sobald aus zwei der Storagegates (2A, 2B) jeweils Ladungsträger den jeweiligen Potentialwall (4A, 4B) des entsprechenden Transfergates (5A, 5B) überwinden und zur zugeordneten Floating-Diffusion (6A, 6B) passieren können, indem der Potentialwall (4A, 4B) der zugeordneten Transfergates (5A, 5B) wieder erhöht wird.

2. Verfahren nach Anspruch 1, **dadurch gekennzeichnet, dass** die Bestimmung der Differenz der beiden Ladungsträgermengen (11A, 11B) zu einem Zeitpunkt stattfindet:
• sobald aus zwei der Storagegates (2A, 2B) jeweils Ladungsträger den jeweiligen Potentialwall (4A, 4B) des entsprechenden Transfergates (5A, 5B) überwinden und zur zugeordneten Floating-Diffusion (6A, 6B) passieren können und/oder wenn das Stoppen der Passage der Ladungsträger zur jeweils zugeordneten Floating-Diffusion (6A, 6B) erfolgt und/oder
• sobald aus keinem der Storagegates (2A, 2B) mehr Ladungsträger den jeweiligen Potentialwall (4A, 4B) des entsprechenden Transfergates (5A, 5B) überwinden und zur zugeordneten Floating-Diffusion (6A, 6B) passieren können, zuvor aber Ladungsträger aus beiden Storagegates (2A, 2B) zur jeweiligen Floating-Diffusion (6A, 6B) passiert sind und/oder
• während aus beiden Storagegates (2A, 2B) Ladungsträger den jeweiligen Potentialwall (4A, 4B) des entsprechenden Transfergates (5A, 5B) überwinden und zur zugeordneten Floating-Diffusion (6A, 6B) passieren.

3. Verfahren nach einem der vorgenannten Ansprüche, **dadurch gekennzeichnet, dass** die Potentiale der Floating-Diffusions (6A, 6B) mit jeweils einem vorgegebenen Referenzpotential-Wert (9) verglichen werden, wobei die Referenzpotential-Werte (9) insbesondere gleich sind, wobei vorzugsweise die Ergebnisse der Vergleiche mit einer logischen Schaltung (10) ausgewertet werden, um die Potentialdifferenz zu ermitteln .

4. Verfahren nach einem der vorgenannten Ansprüche, **dadurch gekennzeichnet, dass** die Änderungen der Höhen der Potentialwälle (4A, 4B) und/oder die Änderungen der Potentialtopftiefen jeweils zeitgleich oder zeitlich versetzt erfolgen.

5. Verfahren nach einem der vorgenannten Ansprüche, **dadurch gekennzeichnet, dass** die Änderung der Topftiefe der Storagegates (2A, 2B) und/oder die Änderung der Höhen der Potentialwälle (4A, 4B) jeweils stetig oder sprunghaft vorgenommen wird.

6. Verfahren nach einem der vorgenannten Ansprüche, **dadurch gekennzeichnet, dass**:
• die im Umwandlungsbereich photoinduzierten Ladungsträger durch Anlegen einer Spannung, insbesondere an ein Driftgate, in einen Trennbereich geleitet werden und/oder
• die Ladungsträger im Trennbereich abwechselnd entsprechend der Modulationsfrequenz in die wenigstens zwei Ladungsträgermengen (11A, 11B) aufgetrennt werden, indem sie in Richtung jeweils eines von wenigstens zwei Modulationsgates gelenkt werden.

7. Entfernungssensor (20) zur Bestimmung einer Entfernung zu einem Objekt durch den Empfang von vom Objekt reflektierter Strahlung, die von einer mit einer Modulationsfrequenz modulierten Strahlungsquelle stammt, umfassend:
• eine Pixelmatrix zur Aufnahme eines Pixelbildes,
• wobei die Pixelmatrix wenigstens zwei Demodulationspixel aufweist, welche jeweils umfassen:
i. einen Umwandlungsbereich zur Erzeugung von photoinduzierten Ladungsträgern aus der empfangenen Strahlung,
ii. eine Trenneinrichtung zur Trennung der Ladungsträger nach einer Modulationsfrequenz in wenigstens zwei Ladungsträgermengen,
iii. wenigstens zwei Storagegates (2A, 2B), wobei jedes der Storagegates (2A, 2B) genau einer der abgetrennten Ladungsträgermengen (11A, 11B) zugeordnet wird und zur Sammlung der zugeordneten Ladungsträgermenge (11A, 11B) ausgebildet ist,
iv. wenigstens zwei Transfergates (5A, 5B), die jeweils genau einem der Storagegates (2A, 2B) zugeordnet sind, welche jeweils als Schleuse für die in dem zugeordneten Storagegate (2A, 2B) gesammelten Ladungsträger zu deren Weiterleitung ausgebildet sind,
v. wenigstens zwei Floating-Diffusions (6A, 6B), die jeweils genau einem der Transfergates (5A, 5B) zugeordnet sind, zur Aufnahme der vom jeweiligen Transfergate (5A, 5B) weitergeleiteten Ladungsträger und zur Einspeisung der Ladungsträger als Spannung in einen Auswertebereich, wobei
• die Transfergates (5A, 5B) dazu ausgebildet sind, die von ihnen jeweils erzeugten Potentialwälle (4A, 4B) hinsichtlich ihrer Höhe zu verändern,eine Vergleichsvorrichtung (7) vorgesehen ist, um ein Absenken der jeweiligen Potentialwälle (4A, 4B) der entsprechenden Transfergates (5A, 5B) durchzuführen, bevor aus zwei der Storagegates (2A, 2B) jeweils Ladungsträger den jeweiligen Potentialwall (4A, 4B) des entsprechenden Transfergates (5A, 5B) überwinden und zur zugeordneten Floating-Diffusion (6A, 6B) passieren können, wobei die Storagegates (2A, 2B) dazu ausgebildet sind, jeweils ihre Topftiefe zu verändern, wobei der Entfernungssensor (20) und/oder die Vergleichsvorrichtung (7) dazu ausgebildet ist/sind:
• die Topftiefe des entsprechenden Potentialtopfes (3A, 3B) des zugeordneten Storagegates (2A, 2B) zu verringern, bis aus zwei der Storagegates (2A, 2B) jeweils Ladungsträger den jeweiligen Potentialwall (4A, 4B) des entsprechenden Transfergates (5A, 5B) überwinden und zur zugeordneten Floating-Diffusion (6A, 6B) passieren können, wobei die Vergleichsvorrichtung (7) dazu ausgebildet ist, die Passage der Ladungsträger zur jeweils zugeordneten Floating-Diffusion (6A, 6B) zu stoppen, sobald aus zwei der Storagegates (2A, 2B) jeweils Ladungsträger den jeweiligen Potentialwall (4A, 4B) des entsprechenden Transfergates (5A, 5B) überwinden und zur zugeordneten Floating-Diffusion (6A, 6B) passieren können, **dadurch gekennzeichnet, dass** die Vergleichsvorrichtung (7) dazu ausgebildet ist, dass, sobald aus zwei der Storagegates (2A, 2B) jeweils Ladungsträger den jeweiligen Potentialwall (4A, 4B) des entsprechenden Transfergates (5A, 5B) überwinden und zur zugeordneten Floating-Diffusion (6A, 6B) passieren können, der Potentialwall (4A, 4B) der zugeordneten Transfergates (5A, 5B) wieder erhöht wird, um die Passage der Ladungsträger zur jeweils zugeordneten Floating-Diffusion (6A, 6B) zu stoppen.

8. Entfernungssensor (20) nach Anspruch 7, **dadurch gekennzeichnet, dass** jedem Demodulationspixel (1) eine Vergleichsvorrichtung zugeordnet ist und/oder dass die Demodulationspixel (21) als Matrix angeordnet sind, wobei jeder Zeile (Z) und/oder jeder Spalte (S) der Matrix (20) genau eine Vergleichsvorrichtung (7) zugeordnet ist.

9. Entfernungssensor (20) nach einem der Ansprüche 7 oder 8, **dadurch gekennzeichnet, dass** die Vergleichsvorrichtung (7) dazu ausgebildet ist, die Differenz der beiden Ladungsträgermengen (11A, 11B) durch Vergleich der Potentiale der Floating-Diffustions (6A, 6B), insbesondere durch Vergleich mit einem vorgegebenen Referenzwert (9), vorzugsweise mit einem vorgegebenen gemeinsamen Referenzwert (9), zu bestimmen.

10. Entfernungssensor (20) nach einem der Ansprüche 7 bis 9, **dadurch gekennzeichnet, dass**:
• die Trenneinrichtung ein Driftgate zur Anziehung der Ladungsträger aus dem Umwandlungsbereich in einen Trennbereich durch Anlegen einer Spannung aufweist und/oder
• wenigstens zwei Modulationsgates vorhanden sind, um die Ladungsträger aus dem Trennbereich aufzutrennen, indem die Ladungsträger abwechselnd entsprechend der Modulationsfrequenz vom Driftgate in Richtung des jeweiligen Modulationsgates gelenkt werden, wobei die Modulationsgates insbesondere an gegenüberliegenden Stellen des Driftgates angeordnet sind.

## Claims

1. Method for reading a demodulation pixel (1, 21) of a distance sensor (20) for determining the distance from an object, for determining the difference between two charge quantities (11A, 11B) independently of the total magnitude of the charge quantities (11A, 11B), comprising the following method steps:
• providing a demodulation pixel (1, 21) for receiving radiation,
• converting the radiation received in a conversion region into photoinduced charge carriers,
• partitioning the charge carriers according to a modulation frequency into at least two charge carrier quantities,
• collecting the separated charge carrier quantities in each case in the potential well (3A, 3B) of one of at least two storage gates (2A, 2B), which are assigned in each case to the charge carrier quantities (11A, 11B),
• closing off the at least two storage gates (2A, 2B) by way of in each case a potential hill (4A, 4B) of a transfer gate (5A, 5B) assigned to each of the storage gates (2A, 2B) as a lock for the charge carriers collected in the assigned storage gate (2A, 2B) from in each case an assigned floating diffusion (6A, 6B) for capturing the charge carriers that have been transferred by the respective transfer gate (5A, 5B) and for feeding the charge carriers as a voltage into an evaluation region, comprising:
• applying a variable control voltage to the transfer gates (5A, 5B) for influencing the potential hill (4A, 4B) and
• lowering the respective potential hills (4A, 4B) of the corresponding transfer gates (5A, 5B) before in each case charge carriers from the storage gates (2A, 2B) can surmount the respective potential hill (4A, 4B) of the corresponding transfer gate (5A, 5B) and pass to the assigned floating diffusion (6A, 6B), wherein the well depth of the corresponding potential well (3A, 3B) of the assigned storage gate (2A, 2B) is reduced until in each case charge carriers from two of the storage gates (2A, 2B) can surmount the respective potential hill (4A, 4B) of the corresponding transfer gate (5A, 5B) and pass to the assigned floating diffusion (6A, 6B),
**characterized in that** the passage of the charge carriers to the respectively assigned floating diffusion (6A, 6B) is stopped as soon as in each case charge carriers from two of the storage gates (2A, 2B) can surmount the respective potential hill (4A, 4B) of the corresponding transfer gate (5A, 5B) and pass to the assigned floating diffusion (6A, 6B) by the potential hill (4A, 4B) of the assigned transfer gates (5A, 5B) being increased again.

2. Method according to Claim 1, **characterized in that** the determination of the difference of the two charge carrier quantities (11A, 11B) takes place at a time:
• as soon as in each case charge carriers from two of the storage gates (2A, 2B) can surmount the respective potential hill (4A, 4B) of the corresponding transfer gate (5A, 5B) and pass to the assigned floating diffusion (6A, 6B) and/or when the passage of the charge carriers to the respectively assigned floating diffusion (6A, 6B) is stopped and/or
• as soon as no more charge carriers from any of the storage gates (2A, 2B) can surmount the respective potential hill (4A, 4B) of the corresponding transfer gate (5A, 5B) and pass to the assigned floating diffusion (6A, 6B), but charge carriers from both storage gates (2A, 2B) have previously passed to the respective floating diffusion (6A, 6B), and/or
• while charge carriers from both storage gates (2A, 2B) surmount the respective potential hill (4A, 4B) of the corresponding transfer gate (5A, 5B) and pass to the assigned floating diffusion (6A, 6B).

3. Method according to either of the preceding claims, **characterized in that** the potentials of the floating diffusions (6A, 6B) are compared with in each case a specified reference potential value (9), wherein the reference potential values (9) are in particular the same, wherein preferably the results of the comparisons are evaluated with a logic circuit (10) to ascertain the potential difference.

4. Method according to one of the preceding claims, **characterized in that** the changes in the heights of the potential hills (4A, 4B) and/or the changes in the potential well depths take place in each case at the same time or with a temporal offset.

5. Method according to one of the preceding claims, **characterized in that** the change in the well depth of the storage gates (2A, 2B) and/or the change in the heights of the potential hills (4A, 4B) is performed in each case continuously or abruptly.

6. Method according to one of the preceding claims, **characterized in that**:
• the charge carriers photoinduced in the conversion region are guided into a partition region by applying a voltage, in particular to a drift gate, and/or
• the charge carriers in the partition region are separated in alternation corresponding to the modulation frequency into the at least two charge carrier quantities (11A, 11B) by being steered in the direction of in each case one of at least two modulation gates.

7. Distance sensor (20) for determining a distance from an object by receiving radiation that is coming from a radiation source modulated with a modulation frequency and that has been reflected by the object, comprising:
• a pixel matrix for recording a pixel image,
• wherein the pixel matrix has at least two demodulation pixels which each comprise:
i. a conversion region for generating photoinduced charge carriers from the radiation received,
ii. a partitioning device for partitioning the charge carriers according to a modulation frequency into at least two charge carrier quantities,
iii. at least two storage gates (2A, 2B), wherein each of the storage gates (2A, 2B) is assigned to exactly one of the partitioned charge carrier quantities (11A, 11B) and is embodied for collecting the assigned charge carrier quantity (11A, 11B),
iv. at least two transfer gates (5A, 5B), which are assigned in each case exactly to one of the storage gates (2A, 2B) that are embodied in each case as a lock for the charge carriers collected in the assigned storage gate (2A, 2B) for their transfer,
v. at least two floating diffusions (6A, 6B), which are assigned in each case exactly to one of the transfer gates (5A, 5B), for capturing the charge carriers that have been transferred by the respective transfer gate (5A, 5B) and for feeding the charge carriers as a voltage into an evaluation region, wherein
• the transfer gates (5A, 5B) are embodied for changing the potential hills (4A, 4B) generated thereby in each case in terms of their height, a comparison apparatus (7) is provided for performing a lowering of the respective potential hills (4A, 4B) of the corresponding transfer gates (5A, 5B), before in each case charge carriers from two of the storage gates (2A, 2B) can surmount the respective potential hill (4A, 4B) of the corresponding transfer gate (5A, 5B) and pass to the assigned floating diffusion (6A, 6B), wherein the storage gates (2A, 2B) are embodied for changing in each case their well depth, wherein the distance sensor (20) and/or the comparison apparatus (7) is/are embodied for:
• reducing the well depth of the corresponding potential well (3A, 3B) of the assigned storage gate (2A, 2B) until in each case charge carriers from two of the storage gates (2A, 2B) can surmount the respective potential hill (4A, 4B) of the corresponding transfer gate (5A, 5B) and pass to the assigned floating diffusion (6A, 6B), wherein the comparison apparatus (7) is embodied for stopping the passage of the charge carriers to the respectively assigned floating diffusion (6A, 6B) as soon as in each case charge carriers from two of the storage gates (2A, 2B) can surmount the respective potential hill (4A, 4B) of the corresponding transfer gate (5A, 5B) and pass to the assigned floating diffusion (6A, 6B), **characterized in that** the comparison apparatus (7) is embodied so that, as soon as in each case charge carriers from two of the storage gates (2A, 2B) can surmount the respective potential hill (4A, 4B) of the corresponding transfer gate (5A, 5B) and pass to the assigned floating diffusion (6A, 6B), the potential hill (4A, 4B) of the assigned transfer gates (5A, 5B) is increased again in order to stop the passage of the charge carriers to the respectively assigned floating diffusion (6A, 6B).

8. Distance sensor (20) according to Claim 7, **characterized in that** each demodulation pixel (1) is assigned a comparison apparatus and/or **in that** the demodulation pixels (21) are arranged in the form of a matrix, with each row (Z) and/or each column (S) of the matrix (20) being assigned exactly one comparison apparatus (7).

9. Distance sensor (20) according to one of Claims 7 or 8, **characterized in that** the comparison apparatus (7) is embodied to determine the difference between the two charge carrier quantities (11A, 11B) by comparing the potentials of the floating diffusions (6A, 6B), in particular by comparison with a specified reference value (9), preferably with a specified common reference value (9) .

10. Distance sensor (20) according to one of Claims 7 to 9, **characterized in that**:
• the partitioning device has a drift gate for attracting the charge carriers from the conversion region into a partition region by applying a voltage and/or
• at least two modulation gates are present for separating the charge carriers from the partition region by the charge carriers being steered in alternation according to the modulation frequency from the drift gate in the direction of the respective modulation gate, wherein the modulation gates are arranged in particular at opposite points of the drift gate.

## Revendications

1. Procédé de lecture d'un pixel de démodulation (1, 21) d'un capteur de distance (20), destiné à déterminer la distance à un objet, afin de déterminer la différence entre deux quantités de charge (11A, 11B) indépendamment de la valeur totale des quantités de charge (11A, 11B), ledit procédé comprenant les étapes suivantes :
• fournir un pixel de démodulation (1, 21) destiné à recevoir un rayonnement,
• convertir le rayonnement, reçu dans une zone de conversion, en porteurs de charge photo-induits,
• séparer les porteurs de charge selon une fréquence de modulation en au moins deux quantités de porteurs de charge,
• collecter les quantités de porteurs de charge séparés à chaque fois dans le puits de potentiel (3A, 3B) de l'une des au moins deux portes de stockage (2A, 2B) qui sont chacune associées aux quantités de porteurs de charge (11A, 11B),
• cloisonner les au moins deux portes de stockage (2A, 2B) par une paroi de potentiel (4A, 4B) d'une porte de transfert (5A, 5B), associée à chacune des portes de stockage (2A, 2B), sous la forme d'un sas destiné aux porteurs de charges, collectés dans les portes de stockage associées (2A, 2B), d'une diffusion flottante associée (6A, 6B) afin de recevoir les porteurs de charge transmis par la porte de transfert respective (5A, 5B) et d'injecter les porteurs de charge sous forme de tension dans une zone d'évaluation, comprenant les étapes suivantes :
• appliquer une tension de commande variable aux portes de transfert (5A, 5B) afin d'influer sur la paroi de potentiel (4A, 4B) et
• abaisser les parois de potentiel respectives (4A, 4B) des portes de transfert correspondantes (5A, 5B) avant que des porteurs de charge provenant des portes de stockage (2A, 2B) ne franchissent la paroi de potentiel respective (4A, 4B) de la porte de transfert correspondante (5A, 5B) et ne puissent passer vers la diffusion flottante associée (6A, 6B), la profondeur du puits de potentiel correspondant (3A, 3B) de la porte de stockage associée (2A, 2B) étant réduite jusqu'à ce que des porteurs de charge provenant de deux des portes de stockage (2A, 2B) franchissent la paroi de potentiel respective (4A, 4B) de la porte de transfert correspondante (5A, 5B) et puissent passer vers la diffusion flottante associée (6A, 6B),
**caractérisé en ce que** le blocage du passage des porteurs de charge vers la diffusion flottante respectivement associée (6A, 6B) est effectué dès que des porteurs de charge de deux des portes de stockage (2A, 2B) franchissent la paroi de potentiel respective (4A, 4B) de la porte de transfert correspondante (5A, 5B) et peuvent passer vers la diffusion flottante associée (6A, 6B) du fait que la paroi de potentiel (4A, 4B) des portes de transfert associées (5A, 5B) est à nouveau augmentée.

2. Procédé selon la revendication 1, **caractérisé en ce que** la détermination de la différence entre les deux quantités de porteurs de charge (11A, 11B) est effectuée à un instant donné :
• dès que des porteurs de charge provenant de deux des portes de stockage (2A, 2B) franchissent la paroi de potentiel respective (4A, 4B) de la porte de transfert correspondante (5A, 5B) et peuvent passer vers la diffusion flottante associée (6A, 6B) et/ou lorsque le blocage du passage des porteurs de charge vers la diffusion flottante respectivement associée (6A, 6B) est effectué et/ou
• dès que plus aucun porteur de charge provenant de l'une des portes de stockage (2A, 2B) ne franchit la paroi de potentiel respective (4A, 4B) de la porte de transfert correspondante (5A, 5B) et ne peut passer vers la diffusion flottante associée (6A, 6B), mais des premiers porteurs de charge provenant des deux portes de stockage (2A, 2B) sont préalablement passés vers la diffusion flottante respective (6A, 6B) et/ou
• tandis que des porteurs de charge provenant des deux portes de stockage (2A, 2B) franchissent la paroi de potentiel respective (4A, 4B) de la porte de transfert correspondante (5A, 5B) et passent vers la diffusion flottante associée (6A, 6B).

3. Procédé selon l'une des revendications précédentes, **caractérisé en ce que** les potentiels des diffusions flottantes (6A, 6B) sont comparés à une valeur de potentiel de référence spécifiée (9), les valeurs de potentiel de référence (9) étant notamment identiques, les résultats des comparaisons étant de préférence évalués avec un circuit logique (10) afin de déterminer la différence de potentiel.

4. Procédé selon l'une des revendications précédentes, **caractérisé en ce que** les variations des hauteurs des parois de potentiel (4A, 4B) et/ou les variations des profondeurs de puits de potentiel sont effectuées en même temps ou de manière décalée dans le temps.

5. Procédé selon l'une des revendications précédentes, **caractérisé en ce que** la variation de la profondeur de puits des portes de stockage (2A, 2B) et/ou la variation des hauteurs des parois de potentiel (4A, 4B) sont effectuées de manière continue ou discontinue.

6. Procédé selon l'une des revendications précédentes, **caractérisé en ce que** :
• les porteurs de charge photo-induits dans la zone de conversion sont acheminés dans une zone de séparation par application d'une tension, en particulier sur une porte de dérive, et/ou
• les porteurs de charge dans la zone de séparation sont séparés alternativement selon la fréquence de modulation en au moins deux quantités de porteurs de charge (11A, 11B) du fait qu'ils sont déviés en direction de l'une des au moins deux portes de modulation.

7. Capteur de distance (20) destiné à déterminer une distance à un objet par réception d'un rayonnement réfléchi par l'objet et provenant d'une source de rayonnement modulée à une fréquence de modulation, ledit capteur de distance comprenant :
• une matrice de pixels destinée à enregistrer une image de pixels,
• la matrice de pixels comportant au moins deux pixels de démodulation qui comprennent chacun :
i. une zone de conversion destinée à générer des porteurs de charge photo-induits à partir du rayonnement reçu,
ii. un moyen de séparation destiné à séparer les porteurs de charge selon une fréquence de modulation en au moins deux quantités de porteurs de charge,
iii. au moins deux portes de stockage (2A, 2B), chacune des portes de stockage (2A, 2B) étant associée à exactement une des quantités de porteurs de charge séparées (11A, 11B) et étant conçue pour collecter la quantité de porteurs de charge associée (11A, 11B),
iv. au moins deux portes de transfert (5A, 5B) qui sont chacune associées à exactement une des portes de stockage (2A, 2B) qui sont chacune conçues comme un sas destiné aux porteurs de charge collectés dans la porte de stockage associée (2A, 2B) afin de transmettre ceux-ci,
v. au moins deux diffusions flottantes (6A, 6B) qui sont chacune associées à exactement une des portes de transfert (5A, 5B) et qui sont destinées à recevoir les porteurs de charge transmis par la porte de transfert respective (5A, 5B) et à injecter les porteurs de charge sous forme d'une tension dans une zone d'évaluation,
• les portes de transfert (5A, 5B) étant conçues pour modifier la hauteur des parois de potentiel (4A, 4B) qu'elles génèrent, un dispositif de comparaison (7) étant prévu pour abaisser les parois de potentiel respectives (4A, 4B) des portes de transfert (5A, 5B) avant que des porteurs de charge provenant de deux des portes de stockage (2A, 2B) ne franchissent la paroi de potentiel respective (4A, 4B) de la porte de transfert correspondante (5A, 5B) et ne peuvent passer vers la diffusion flottante (6A, 6B), les portes de stockage (2A, 2B) étant conçues pour faire varier leur profondeur de puits, le capteur de distance (20) et/ou le dispositif de comparaison (7) étant conçus pour :
• réduire la profondeur du puits de potentiel correspondant (3A, 3B) de la porte de stockage associée (2A, 2B) jusqu'à ce que des porteurs de charge provenant de deux des portes de stockage (2A, 2B) franchissent la paroi de potentiel respective (4A, 4B) de la porte de transfert correspondante (5A, 5B) et puissent passer vers la diffusion flottante associée (6A, 6B), le dispositif de comparaison (7) étant conçu pour bloquer le passage des porteurs de charges vers la diffusion flottante respectivement associée (6A, 6B) dès que des porteurs de charge provenant de deux des portes de stockage (2A, 2B) franchissent la paroi de potentiel respective (4A, 4B) de la porte de transfert correspondante (5A, 5B) et peuvent passer vers la diffusion flottante associée (6A, 6B), **caractérisé en ce que** le dispositif de comparaison (7) est conçu pour que, dès que des porteurs de charge provenant de deux des portes de stockage (2A, 2B) franchissent la paroi de potentiel respective (4A, 4B) de la porte de transfert correspondante (5A, 5B) et peuvent passer vers la diffusion flottante associée (6A, 6B), la paroi de potentiel (4A, 4B) de la porte de transfert associée (5A, 5B) soit à nouveau augmentée afin de bloquer le passage des porteurs de charge vers la diffusion flottante respectivement associée (6A, 6B).

8. Capteur de distance (20) selon la revendication 7, **caractérisé en ce qu'**un dispositif de comparaison est associé à chaque pixel de démodulation (1) et/ou **en ce que** les pixels de démodulation (21) sont disposés sous forme de matrice, chaque ligne (Z) et/ou chaque colonne (S) de la matrice (20) étant associée à exactement un dispositif de comparaison (7).

9. Capteur de distance (20) selon l'une des revendications 7 ou 8, **caractérisé en ce que** le dispositif de comparaison (7) est conçu pour déterminer la différence entre les deux quantités de porteurs de charge (11A, 11B) en comparant les potentiels de diffusion flottante (6A, 6B), notamment par comparaison avec une valeur de référence prédéterminée (9), de préférence avec une valeur de référence commune spécifiée (9).

10. Capteur de distance (20) selon l'une des revendications 7 à 9, **caractérisé en ce que** :
• le moyen de séparation comporte une porte de dérive destinée à attirer les porteurs de charge de la zone de conversion jusque dans une zone de séparation par application d'une tension et/ou
• au moins deux portes de modulation sont présentes afin de séparer les porteurs de charge de la zone de séparation du fait que les porteurs de charge sont déviés de la porte de dérive en direction de la porte de modulation respective alternativement en fonction de la fréquence de modulation, les portes de modulation étant disposées notamment à des points opposés de la porte de dérive.
